(19) **Europäisches Patentamt / European Patent Office / Office européen des brevets**

(11) **EP 4 315 437 B1**

(12) **FASCICULE DE BREVET EUROPEEN**

(45) Date de publication et mention
de la délivrance du brevet:
**10.09.2025   Bulletin 2025/37**

(21) Numéro de dépôt: **22717189.9**

(22) Date de dépôt: **23.03.2022**

(51) Classification Internationale des Brevets (IPC):
*H01C 7/00* (2006.01)      *H01C 17/065* (2006.01)
*H01L 23/373* (2006.01)    *H10H 20/01* (2025.01)
*H10H 20/858* (2025.01)

(52) Classification Coopérative des Brevets (CPC):
**H01C 17/06553; H01C 7/003; H01C 7/008;
H10H 20/0365; H10H 20/8581; H10H 20/8582;**
H01L 23/3735; H01L 23/3736

(86) Numéro de dépôt international:
**PCT/EP2022/057715**

(87) Numéro de publication internationale:
**WO 2022/207435 (06.10.2022 Gazette 2022/40)**

(54) **DISSIPATEUR THERMIQUE POUR COMPOSANT ÉLECTRONIQUE ET PROCÉDÉ DE FABRICATION ASSOCIÉ**

WÄRMESENKE FÜR EIN ELEKTRONISCHES BAUELEMENT UND ENTSPRECHENDES HERSTELLUNGSVERFAHREN

HEAT SINK FOR AN ELECTRONIC COMPONENT AND CORRESPONDING METHOD OF MANUFACTURING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **29.03.2021   FR 2103227**

(43) Date de publication de la demande:
**07.02.2024   Bulletin 2024/06**

(73) Titulaire: **Valeo Vision**
**93012 Bobigny Cedex (FR)**

(72) Inventeurs:
• **MENN, Thibaut**
  **49000 Angers (FR)**
• **VIVET, Laurent**
  **93012 Bobigny (FR)**

• **LEON, Renan**
  **78322 Le Mesnil-Saint-Denis Cedex (FR)**
• **BISSON, Jean-Francois**
  **94000 Creteil (FR)**
• **DECROUY, Baptiste**
  **95892 Cergy Pontoise (FR)**
• **BONVALLAT, Guillaume**
  **95892 Cergy Pontoise (FR)**

(74) Mandataire: **Valeo Visibility**
**IP department**
**34, rue Saint André**
**93012 Bobigny Cedex (FR)**

(56) Documents cités:
**KR-A- 20130 096 884     US-A1- 2019 206 761**

## Description

### Domaine technique

La présente invention concerne le domaine des dissipateurs thermiques. Elle trouve pour application particulièrement avantageuse le domaine de l'éclairage et/ou de la signalisation de véhicule automobile, en particulier pour le refroidissement des diodes électroluminescentes.

### ETAT DE LA TECHNIQUE

La dissipation thermique est un problème général lors du fonctionnement des composants électroniques, et en particulier pour les diodes électroluminescentes dont les circuits produisent beaucoup de chaleur. C'est notamment le cas dans le domaine de l'éclairage automobile.

Des dissipateurs thermiques sont généralement associés aux circuits et/ou composants électroniques pour faciliter leur refroidissement par convection naturelle.

Pour accroître l'échange thermique des dissipateurs en convection naturel, il existe plusieurs solutions connues. Des approches géométriques consistent à accroître la surface d'échange du dissipateur avec l'air ambiant. Typiquement, des ailettes sont pour cela ajoutées au dissipateur. Cela augmente toutefois l'encombrement des dissipateurs et nécessite de les usiner ou de les mouler de façon spécifique, complexifiant leur fabrication et augmentant donc leur coût.

On peut aussi chercher à améliorer les propriétés radiatives du dissipateur par une modification chimique de son état de surface. Pour cela, les solutions existantes consistent à traiter la surface du dissipateur par exemple par cataphorèse, anodisation, par dépôt physique en phase vapeur ou encore par dépôt assisté par plasma. Il est notamment connu du document US 2007/0210265 A1 un procédé de formation d'une couche de carbone amorphe et d'une couche de carbure de métal sur un dissipateur par dépôt physique en phase vapeur. Ces traitements restent toutefois coûteux et complexes à mettre en œuvre.

Le document US 2019/206761 A1 divulgue un élément métallique comprenant un substrat métallique et une couche métallique poreuse, ainsi qu'un composite comprenant l'élément métallique et un élément en résine. Le substrat métallique présente une surface, est constitué d'un matériau métallique, et comprend une région formée comme une couche irrégulière ayant une forme en relief par rapport à ladite surface. La couche métallique poreuse a une forme en treillis et est formée sur la couche irrégulière. Cette dernière comprend une pluralité de saillies s'étendant dans une direction perpendiculaire à la surface en question.

Le document KR 2013 0096884 A divulgue un substrat de base destiné à la formation d'un motif de circuit et une méthode de fabrication associée, et concerne plus particulièrement un substrat de base permettant de former un motif de circuit, capable de fixer solidement une couche isolante et une couche de circuit conductrice à un substrat métallique. Le substrat de base pour la couche isolante dans la couche métallique de la carte, ainsi que la formation du motif de circuit, peuvent améliorer considérablement la dissipation thermique et garantir l'adhérence à la couche de circuit conductrice.

Un objet de la présente invention est donc de proposer un dissipateur thermique amélioré et un procédé de fabrication amélioré d'un dissipateur thermique par rapport aux solutions existantes.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit un dissipateur thermique pour composant électronique comprenant un corps doté d'une couche extérieure. Au moins une partie de la couche extérieure comprend une couche superficielle présentant une surface exposée radiative et une couche immédiatement sous-jacente à la couche superficielle.

Selon l'invention:

- la couche sous-jacente est en matériau à base ou fait d'un métal ou d'un alliage de métaux et la couche superficielle est à base ou faite d'un oxyde dudit matériau,
- la couche extérieure comprend des nodules juxtaposés,
- la couche superficielle présente une épaisseur moyenne comprise entre 5 $\mu$m et 30 $\mu$m.

La surface exposée radiative est ainsi formée d'un oxyde de métal, ce qui permet d'accroître l'émissivité de la surface radiative dans le visible et l'infra-rouge. En outre, les nodules forment une microstructure de la couche extérieure induisant une forte augmentation de la rugosité de surface, et donc une augmentation significative de la surface radiative par rapport aux solutions existantes. Le dissipateur combine de façon originale un état chimique de surface favorisant l'émission thermique, et une structure favorisant géométriquement l'échange thermique, pour améliorer de façon synergique son pouvoir de dissipation thermique.

Un deuxième aspect de l'invention concerne un procédé de fabrication d'un dissipateur thermique pour composant électronique tel que défini dans la revendication 10.

Le traitement permet ainsi de former, à partir de la couche extérieure du corps, une couche superficielle présentant une surface exposée radiative et une couche immédiatement sous-jacente à la couche superficielle, la couche sous-jacente étant en matériau à base ou fait dudit métal ou dudit alliage et la couche superficielle étant à base ou faite d'un oxyde dudit matériau, la couche extérieure comprenant des nodules juxtaposés d'oxyde dudit matériau.

On comprend donc que le procédé permet de fabriquer le dissipateur thermique selon le premier aspect de l'invention et d'obtenir les avantages liés. En effet ce traitement par laser impulsionnel, communément appelé laser nanopulsé, induit à la fois l'oxydation du métal de la couche extérieure pour former la couche superficielle, et la formation des nodules. Ce traitement présente en outre un coût bien inférieur et une rapidité supérieure aux traitements par cataphorèse, anodisation, par dépôt physique en phase vapeur ou encore par dépôt assisté par plasma.

Lors de ce traitement, le corps du dissipateur est chauffé très brièvement lors des impulsions du faisceau laser. Le procédé ne produit localement qu'une très faible élévation de température, typiquement inférieure à 10°C. Ainsi, le procédé peut être mis en œuvre sur un produit fini, tel qu'un circuit imprimé présentant une base métallique, et/ou un dissipateur sur lequel le composant électronique est déjà monté en conduction thermique, sans risque pour d'éventuels composants, colles, joints, et divers éléments en matière plastique. Le procédé peut donc comprendre l'assemblage du ou des composants électroniques, éventuellement d'un circuit imprimé, et du dissipateur. Cet assemblage peut être préalable au traitement par application du laser impulsionnel. La pièce après traitement ne nécessite en outre pas d'être refroidie, le procédé peut donc être exempt d'une étape de refroidissement suite au traitement laser. Par ailleurs, ce procédé ne nécessite pas de traitement préalable de la surface traitée, par exemple d'un nettoyage, avant et/ou après le traitement laser.

Un troisième aspect concerne un dispositif comprenant au moins un composant électronique monté en conduction thermique sur le dissipateur thermique selon le premier aspect.

Selon plusieurs exemples de réalisation pris isolément ou en combinaison:

- le dispositif comprend un circuit imprimé sur lequel est monté le composant électronique, le circuit imprimé comprenant une base en métal, de préférence en aluminium, formant le dissipateur,
- le dispositif comprend un circuit imprimé sur lequel est monté le composant électronique, par exemple un circuit imprimé comprenant une base en matière plastique, le dissipateur thermique étant monté en conduction thermique sur le circuit imprimé,
- le composant électronique est une diode électroluminescente,
- le dispositif est un dispositif lumineux d'éclairage ou de signalisation de véhicule automobile, notamment un feu arrière de véhicule, un module d'éclairage d'un projecteur, ou un projecteur, notamment comprenant ce module d'éclairage.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

[Fig.1] La [Fig.1] représente une vue en coupe transversale de la couche supérieure du corps du dissipateur, avant le traitement par laser impulsionnel, selon un exemple de réalisation.
[Fig.2] La [Fig.2] représente une vue en coupe transversale de la couche supérieure du corps du dissipateur, obtenue après le traitement par laser impulsionnel, selon un exemple de réalisation.
[Fig.3] La [Fig.3] représente une vue du dessus de la couche supérieure du corps du dissipateur, obtenue après le traitement par laser impulsionnel, selon l'exemple illustré en [Fig.2].
[Fig.4] La [Fig.4] représente une vue d'ensemble d'un dispositif comprenant le dissipateur thermique, selon un exemple de réalisation.
[Fig.5A] Les figures 5A et 5B représentent une vue schématique du traitement par laser impulsionnel.
[Fig.5B]

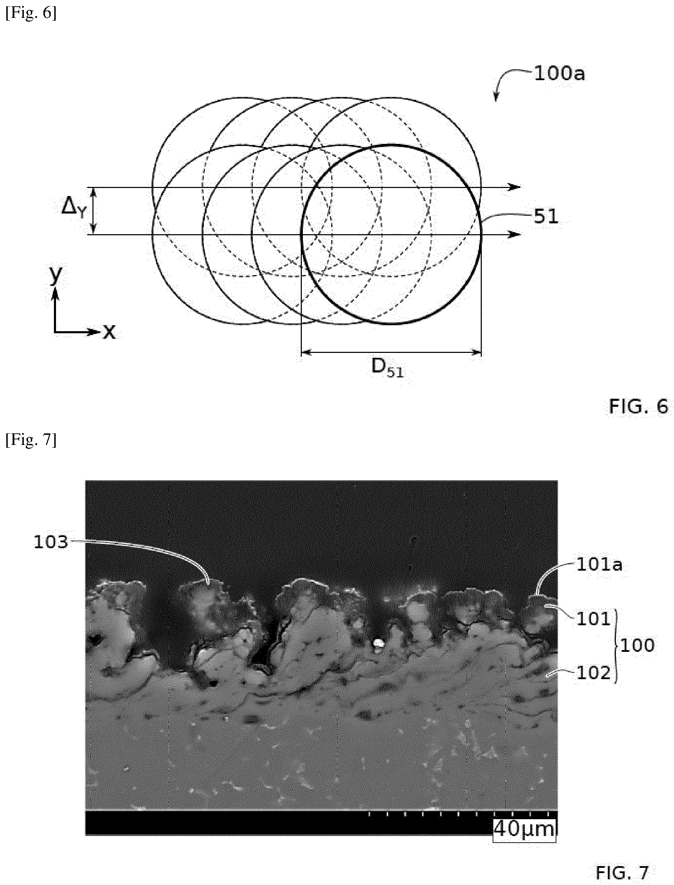

[Fig.6] La [Fig.6] représente une vue schématique des zones d'impact du laser sur la surface du corps du dissipateur, selon un exemple de réalisation.
[Fig.7] La [Fig.7] représente une vue en coupe transversale en microscopie électronique à balayage de la couche supérieure du corps du dissipateur, obtenue après le traitement par laser impulsionnel, selon un exemple de réalisation.

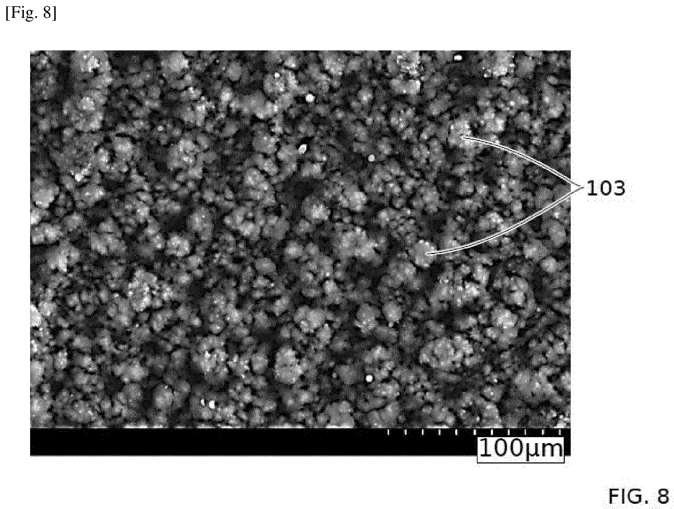

[Fig.8] La [Fig.8] représente une vue du dessus en microscopie électronique à balayage de la couche supérieure du corps du dissipateur, obtenue après le traitement par laser impulsionnel, selon l'exemple illustré en [Fig.7].

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des différentes couches et des nodules ne sont pas nécessairement représentatives de la réalité.

## DESCRIPTION DÉTAILLÉE

Selon l'invention, la couche superficielle présente une épaisseur moyenne sensiblement comprise entre 5 $\mu$m et 30 $\mu$m ; cela permet tout en conservant les propriétés thermiques mentionnées ci-dessus d'assurer un bon recouvrement des nodules et de la couche entre les nodules, et permet également de conserver les propriétés mécaniques dudit corps.

Avant d'entamer une revue détaillée de modes de réalisation de l'invention, sont énoncées ci-après des caractéristiques optionnelles du premier aspect de l'invention qui peuvent éventuellement être utilisées en association ou alternativement :

- le métal est choisi parmi le magnésium, le fer, l'aluminium, l'acier, cuivre et de préférence l'aluminium ;
- le métal est de l'aluminium et l'oxyde est de l'alumine ;
- la couche superficielle présente une épaisseur moyenne supérieure ou égale à 5 $\mu$m ; ceci permet d'optimiser le rayonnement, en particulier en augmentant le rayonnement de la couche d'oxyde par rapport à celle du métal ; la demanderesse s'est aperçu que cela améliorait ainsi la dissipation thermique par le dissipateur ;
-
- la couche superficielle présente une épaisseur moyenne sensiblement comprise entre 5 $\mu$m et 15 $\mu$m ;
- la couche superficielle présente une épaisseur moyenne sensiblement comprise entre 15 $\mu$m et 30 $\mu$m ; cet intervalle est particulièrement optimal en termes de bon recouvrement des nodules ainsi que dans les zones inter-nodulaires, et donc des meilleures propriétés radiatives de la surface, tout en conservant les propriétés mécaniques et thermiques du reste dudit corps ;
- la couche superficielle présente un taux de porosité en volume inférieure à 4% ; cela permet d'avoir de meilleures propriétés radiatives en absorption et en émission, qui sont liées à ses propriétés diélectriques, améliorant ainsi la dissipation thermique ;
- les nodules sont de forme globalement cylindrique ;
- chaque nodule présente une section de forme variable sur la hauteur de ce nodule ; autrement dit la section du nodule n'est pas de forme constante sur toute la hauteur du nodule ; notamment les modules peuvent ne pas avoir de formes régulières de l'un à l'autre, même quand ils ont une forme globalement cylindrique ;
- les nodules présentent en moyenne :

  - une première dimension, et plus particulièrement un diamètre, selon une direction sensiblement parallèle au plan d'extension principale de la couche extérieure, sensiblement inférieure ou égale à 50 $\mu$m, de préférence sensiblement comprise entre 10 $\mu$m et 30 $\mu$m, plus préférentiellement encore sensiblement égale à 20 $\mu$m,
  - une deuxième dimension, et plus particulièrement une hauteur, selon une direction sensiblement normale au plan d'extension principale de la couche extérieure, sensiblement inférieure ou égale à 50 $\mu$m, de préférence sensiblement comprise entre 20 $\mu$m et 40 $\mu$m, plus préférentiellement encore sensiblement égale à 30 $\mu$m ;

- les nodules sont espacés entre eux d'une distance moyenne, selon une direction parallèle au plan d'extension principale de la couche extérieure, sensiblement inférieure ou égale à 50 $\mu$m ;
- les nodules sont formés d'une combinaison de la couche superficielle et d'au moins une partie de la couche sous-jacente.

Des caractéristiques optionnelles du deuxième aspect de l'invention sont énoncées ci-après, qui peuvent éventuellement être utilisées en association ou alternativement :

- la durée des impulsions laser est inférieure à 20 ns,
- le taux de recouvrement est sensiblement supérieur ou égal à 75 %,
- le faisceau laser présente une profondeur de champ sensiblement égale à 3 mm,
- lors de l'impulsion du faisceau laser, la zone d'impact du faisceau laser sur la surface de la couche extérieure présente une plus grande dimension latérale, par exemple un diamètre, choisie sur une plage de valeur allant de quelques dizaines de $\mu$m à plusieurs cm, de préférence de quelques dizaines de $\mu$m à plusieurs centaines de $\mu$m, en fonction de

la taille de la zone à traiter,

- lors de l'impulsion du faisceau laser, la zone d'impact du faisceau laser sur la surface de la couche extérieure présente une plus grande dimension latérale, par exemple un diamètre, sensiblement inférieure ou égale à 500 $\mu$m, de préférence à 400 $\mu$m, plus préférentiellement encore à 100 $\mu$m,

- lors de l'impulsion du faisceau laser, la zone d'impact du faisceau laser sur la surface de la couche extérieure est circulaire ou rectangulaire,

- la surface de la couche extérieure présente une rugosité maximale Rz sensiblement inférieure ou égale à 20 $\mu$m, de préférence sensiblement inférieure ou égale à 15 $\mu$m, de préférence sensiblement inférieure ou égale à 5 $\mu$m, de préférence sensiblement égale à 3 $\mu$m, préalablement au traitement,

- la longueur d'onde du faisceau laser appartient à un domaine choisi parmi l'infra-rouge, par exemple la longueur d'onde est comprise entre 780 nm et 0,1 mm, le visible, par exemple la longueur d'onde est comprise entre 380 nm et 780 nm, et l'ultraviolet, par exemple la longueur d'onde est comprise entre 100 nm et 380 nm.

- le traitement par laser impulsionnel peut se faire en air ambiant, ou bien en présence d'une atmosphère oxydante comprenant un gaz oxydant, par exemple du dioxygène à une proportion sensiblement supérieure à 20 %.

Il est précisé que dans le cadre de la présente invention, les expressions du type « égal, inférieur, supérieur » s'entendent de comparaisons pouvant accommoder certaines tolérances, notamment selon l'échelle de grandeur des valeurs comparées et les incertitudes de mesure. De façon similaire, l'expression « compris entre » désigne une gamme de valeur pouvant accommoder certaines tolérances, notamment selon l'échelle de grandeur des valeurs de la gamme et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Le terme « sur » ne signifie pas nécessairement « directement sur ». Ainsi, lorsque l'on indique qu'une pièce ou qu'un élément A est en appui « sur » une pièce ou un élément B, cela ne signifie pas que les pièces ou éléments A et B soient nécessairement en contact direct avec l'autre. Ces pièces ou éléments A et B peuvent être soit en contact direct soit être en appui l'une sur l'autre par l'intermédiaire d'une ou plusieurs autres pièces.

On entend par un élément à base d'un matériau A, un élément comprenant ce matériau A et éventuellement d'autres matériaux.

Dans la description qui suit, les épaisseurs de couche ou les hauteurs d'un élément sont généralement mesurées selon des directions perpendiculaires au plan de la face supérieure du corps sur lequel la couche est disposée. Ainsi, les épaisseurs sont généralement prises selon une direction verticale sur les vues en coupe transversale représentées. Dans le cas d'un élément en trois dimensions, par exemple un nodule, l'épaisseur d'une couche s'étendant sur un flanc de cet élément peut être mesurée perpendiculairement à ce flanc.

Par une dimension « moyenne » d'un élément tel que d'une couche ou d'un nodule, on entend que cette dimension est moyennée sur une surface suffisante ou sur un nombre de nodules suffisant pour obtenir un échantillon statistique suffisant. De préférence, l'épaisseur moyenne d'une couche est moyennée sur une aire au moins sensiblement égale à 0,20 mm$^2$, de préférence au moins sensiblement égale à 0,25 mm$^2$, par exemple sur une aire carrée de 500 $\mu$m de côté.

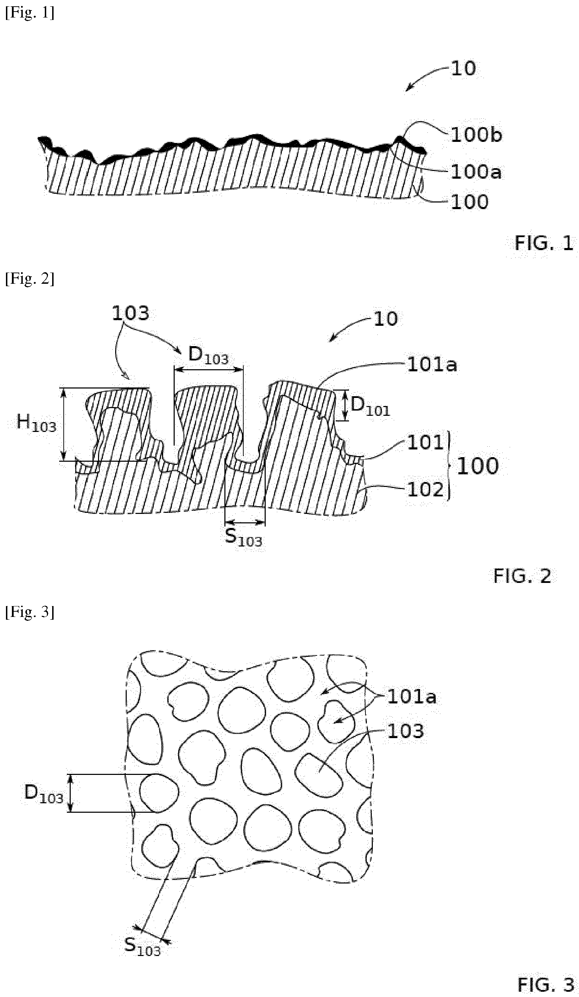

Le dissipateur thermique 1, et son procédé de fabrication sont maintenant décrits en référence aux figures 1 à 3.

Dans le procédé de fabrication, le corps 10 du dissipateur 1 est fourni. Ce corps est doté d'une couche extérieure 100 en matériau à base ou fait d'un métal, ou d'un alliage de métaux, comme par exemple illustré en [Fig.1]. L'extérieur du corps 10 peut être entièrement formé par cette couche extérieure 100. À titre non limitatif, on considère dans la suite que le corps 10 est entièrement formé de cette couche extérieure 100, et fait d'un métal. La couche extérieure présente une surface 100a qui va être au moins en partie traitée par l'application d'un faisceau laser impulsionnel, ci-après désigné traitement laser, c'est-à-dire que la surface 100a est soumise à un rayonnement laser de façon intermittente par au moins une pluralité d'impulsions laser de haute densité de puissance, décrite plus en détail ultérieurement.

Selon l'exemple illustré en [Fig.1], avant le traitement laser, la surface peut être relativement peu rugueuse. Typiquement, la surface 100a de couche extérieure 100 présente une rugosité maximale Rz sensiblement inférieure ou égale à 20 $\mu$m, de préférence sensiblement inférieure ou égale à 15 $\mu$m, plus préférentiellement sensiblement inférieure ou égale à 5 $\mu$m, de préférence sensiblement égale à 3 $\mu$m.

Le traitement laser induit une pulvérisation de la couche extérieure 100 induisant l'oxydation du métal du corps et une microstructuration de la surface 100a. Ainsi, et comme par exemple illustré par les figures 2 et 3, il se forme en surface une couche superficielle 101 à base ou faite d'un oxyde de métal, ou d'alliage de métaux, surmontant directement une couche sous-jacente 102 à base ou faite du métal ou de l'alliage de métaux. Cette modification chimique est réalisée sans nécessiter le dépôt d'une couche additionnel, généralement obtenu par des procédés complexes et coûteux.

Une transformation topographique de la surface 100a est en outre induite, pour aboutir à la surface 101a par exemple illustrée en [Fig.2]. Lors du développement de l'invention, il a en effet été constaté que des nodules 103 étaient formés en surface du corps 10.

Le procédé combine donc une texturation profonde des surfaces métallique, typiquement sur plusieurs dizaines de $\mu$m, et à une oxydation induite par photochimie. L'oxydation induit une augmentation des propriétés d'émissivité du corps 10 du dissipateur, notamment dans le visible et l'infra-rouge. La formation des nodules augmente la rugosité de la surface 101a par rapport à celle de la surface 100a, et donc d'accroître très significativement la surface radiative du corps 10. Ainsi le corps du dissipateur présente un pouvoir dissipant accru, pour se rapprocher des propriétés d'émission d'un corps noir.

Avant le traitement laser, la surface 100a peut en outre être recouverte de composés résiduels 100b, tels que des résidus organiques et/ou de débris métalliques, comme illustré en [Fig.1]. Ces composés résiduels proviennent typiquement des différentes opérations que le corps 10 du dissipateur a subi lors de sa fabrication, tels que par moulage et/ou usinage. Ces composés résiduels seront pulvérisés lors du traitement laser. Le procédé peut ainsi être exempt d'une étape de nettoyage de la surface de la couche extérieure préalablement et/ou suite à son traitement par laser impulsionnel. Ceci représente un avantage conséquent par rapport aux techniques de dépôts d'une couche radiative en surface du corps 10, qui nécessitent le meilleur état de surface possible pour être reproductibles.

La structuration de la couche extérieure 100 après traitement laser est maintenant décrite plus en détail en référence aux figures 2 et 3. Les nodules 103 sont de préférence répartis de façon homogène sur la surface 101a c'est à dire que leur nombre par unité de surface est sensiblement identique en toute portion d'une même taille déterminée de la surface 101a du corps, et plus particulièrement pour une taille suffisamment grande pour observer un échantillon statistique suffisant.

Les nodules 103 peuvent présenter une forme globalement cylindrique, comme l'illustre la vue de dessus illustrée par la [Fig.3]. Par « globalement circulaire », on entend que chaque nodule 103 s'inscrit dans un cylindre défini depuis le haut du nodule 103. La section du nodule 103 n'est pas nécessairement circulaire, comme le montre la [Fig.3]. La section du nodule 103 n'est en outre pas nécessairement de forme constante sur toute la hauteur du nodule 103, comme le montre la [Fig.2]. La forme globalement cylindrique peut présenter un axe central sensiblement perpendiculaire au plan d'extension principale de la couche extérieure 100. Le traitement laser structurant la couche extérieure 100 sur une profondeur allant jusqu'à plusieurs dizaines de $\mu$m, les nodules 103 sont plus particulièrement de taille micrométrique.

Ainsi, comme dans l'exemple illustré, chaque nodule 103 peut présenter une section de forme variable sur la hauteur de ce nodule 103. En particulier, les modules 103 n'ont pas de formes régulières de l'un à l'autre, même s'ils sont globalement cylindriques. D'une manière générale, cette structure de nodules peut être obtenue plus particulièrement avec le procédé selon la présente invention, à la différence de procédés d'ablation ou d'usinage classiques.

Comme illustré en [Fig.2], ils peuvent présenter un diamètre moyen $D_{103}$ sensiblement inférieur ou égal à 50 $\mu$m, de préférence sensiblement comprise entre 10 $\mu$m et 30 $\mu$m, plus préférentiellement encore sensiblement égale à 20 $\mu$m. Ils peuvent en outre présenter une hauteur moyenne $H_{103}$ sensiblement inférieure ou égale à 50 $\mu$m, de préférence sensiblement comprise entre 20 $\mu$m et 40 $\mu$m, plus préférentiellement encore sensiblement égale à 30 $\mu$m. Selon un exemple, les nodules 103 sont juxtaposés en étant séparés par une zone inter-nodulaire. Les nodules peuvent ainsi être espacés entre eux d'une distance moyenne $S_{103}$, selon une direction parallèle au plan d'extension principale de la couche extérieure 100, sensiblement inférieure ou égale à 50 $\mu$m, de préférence à 20 $\mu$m, et plus préférentiellement sensiblement égale à 10 $\mu$m. Il a été observé que ces géométries permettaient d'augmenter par environ six la surface radiative 101a, par rapport à une surface 100a non traitée.

Selon l'épaisseur de la couche superficielle 101 d'oxyde, au vu des exemples de structures décrits ci-dessus, on comprend que les nodules 103 peuvent être formés uniquement par la couche superficielle 101 d'oxyde, ou par une combinaison de la couche superficielle 101 et d'au moins une partie de la couche sous-jacente 102, comme illustré en [Fig.2].

L'épaisseur moyenne de la couche superficielle 101 d'oxyde peut être sensiblement inférieure à 30 $\mu$m, et de préférence sensiblement comprise entre 15 $\mu$m et 30 $\mu$m. Cette épaisseur assure un bon recouvrement des nodules 103 ainsi que dans les zones inter-nodulaires, et donc des meilleures propriétés radiatives de la surface 101a, tout en conservant les propriétés mécaniques et thermiques du reste du corps 10.

De façon non exhaustive, le métal du corps 10 peut être choisi parmi le magnésium, le fer, l'acier, cuivre et l'aluminium. De préférence, le métal est de l'aluminium et l'oxyde formé lors du traitement laser est de l'alumine. L'aluminium est un excellent conducteur thermique et peut être facilement travaillé à basse température et déformé sans se rompre, ce qui en fait un excellent matériau pour former des dissipateurs thermiques de formes variées. En outre, l'alumine est neuf fois plus radiative thermiquement que l'aluminium. Les propriétés radiatives de la couche superficielle 101 et notamment de la surface radiative 101a, sont encore améliorées.

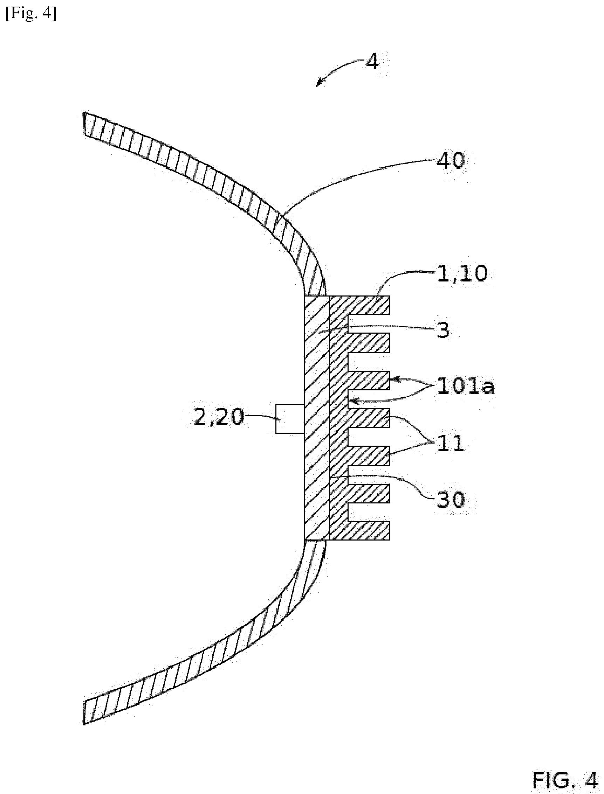

Le dissipateur thermique 1 est donc particulièrement avantageux pour le refroidissement de composant électronique et/ou d'un circuit imprimé. Plusieurs exemples de dispositifs sont maintenant décrits en référence à la [Fig.4].

Le dispositif 4 comprend au moins un composant électronique 2 monté en conduction thermique sur le dissipateur thermique 1. Pour cela, le composant électronique 2 peut être monté sur un circuit imprimé 3. Le circuit imprimé 3 peut être monté en conduction thermique sur le dissipateur 1. Pour cela, le circuit imprimé 3 peut être monté sur le dissipateur par l'intermédiaire d'une interface thermique 30, telle qu'une colle thermique comme illustré en [Fig.4]. Cet exemple s'applique plus particulièrement pour les circuits imprimés à base de matière plastique, par exemple en résine époxyde et/ou en polyimide. Selon un autre exemple non illustré, le circuit imprimé 3 sur lequel est monté le composant électronique 2 comprend une base en métal, et de préférence en aluminium, formant le dissipateur 1. Le dissipateur 1 peut en outre comprendre des ailettes 11 de refroidissement, dont la surface émissive 101a peut présenter les caractéristiques précédemment décrites.

La surface radiative 101a du dissipateur peut être disposée sur une face du corps 10 distincte d'une face sur laquelle le composant électronique 2 et/ou le circuit imprimé 3 est monté, de préférence une face opposée, comme par exemple illustré en [Fig.4].

Le composant électronique 2 peut être une source de lumière, pour au moins une fonction choisie parmi une fonction d'éclairage et une fonction de signalisation, et plus particulièrement pour des véhicules automobiles. Pour cela, la source peut être une diode électroluminescente 20 (abrégé dans la suite LED, de l'anglais *Light-Emitting Diode*). Pour les applications en automobiles, des LED de haute puissance sont généralement utilisées. La plus grande partie de l'énergie d'une LED est convertie en chaleur plutôt qu'en lumière. Si cette chaleur ne peut pas être dissipée, l'efficacité de la LED est diminuée et sa durée de vie est raccourcie.

Le dissipateur thermique 1 est donc particulièrement avantageux pour des applications dans un dispositif lumineux 4 d'éclairage ou de signalisation de véhicule automobile. Le dispositif 4 peut pour cela comprendre un réflecteur 40 sur lequel est monté une LED 20, elle-même montée en conduction thermique avec le dissipateur 1.

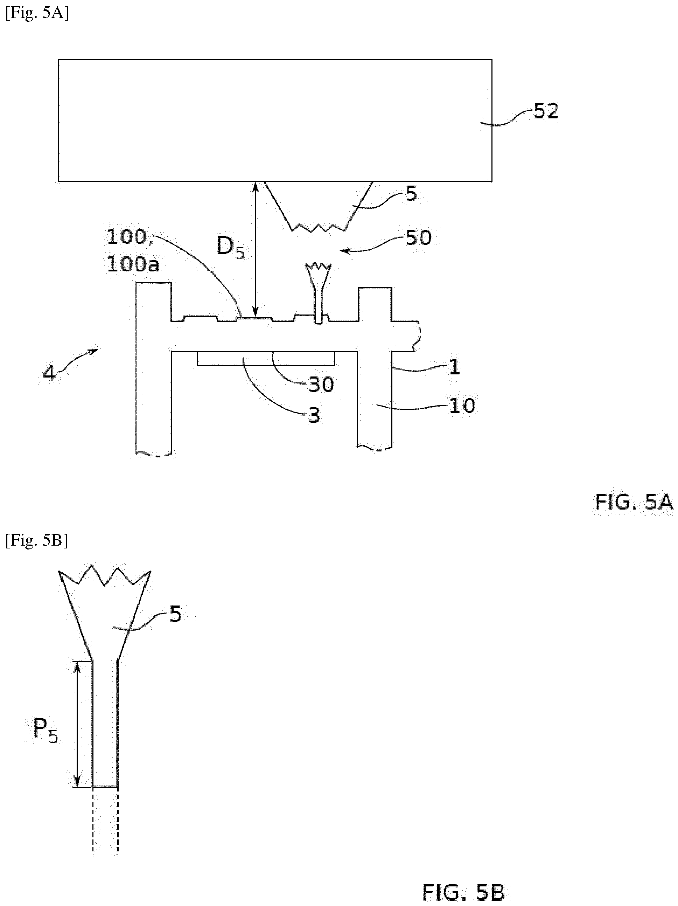

Nous détaillons maintenant les caractéristiques du procédé de fabrication du dissipateur thermique, en référence aux figures 5 et 6. Pour obtenir l'oxydation de la couche superficielle 102 et la formation de nodule 103, le traitement laser met en œuvre un laser impulsionnel générant des impulsions de durée inférieure à 100ns. La densité de puissance est d'au moins 100 MW.cm$^{-2}$. En outre, le faisceau laser 5 est balayé sur la surface 100a du corps avec un taux de recouvrement entre les zones d'impact d'impulsions distinctes sensiblement supérieur ou égal à 60 %. Lors du développement de l'invention, il a été découvert de façon surprenante que cet assortiment de paramètres permettait d'aboutir à la structure précédemment décrite.

Les impulsions laser étant de haute densité de puissance mais sur une très courte durée, le traitement laser induit un très faible échauffement du corps 10 du dissipateur, typiquement inférieur à 10 °C. Le traitement laser peut donc être appliqué à un produit fini, par exemple sur un dispositif 4 comprenant le dissipateur 1 et un circuit imprimé 3 et/ou un composant électronique 2 monté sur le dissipateur 1. Le procédé peut donc comprendre l'assemblage du circuit imprimé 3 et/ou d'un composant électronique 2 sur le dissipateur 1, de préférence préalablement au traitement du corps 10 du dissipateur 1. Le traitement laser peut plus particulièrement être appliqué sur une face distincte d'une face sur laquelle est monté le circuit imprimé 3 et/ou le composant électronique 2. De façon alternative ou complémentaire, et notamment selon la taille du faisceau laser, le traitement laser peut être appliqué sur la même face, à un endroit distinct du placement du circuit imprimé 3. Le traitement laser est réalisé sans risque pour le circuit imprimé ni des composants ou un joint de colle.

Par ailleurs, d'une manière générale, un recouvrement d'au moins 60 % en combinaison avec une des impulsions laser inférieure à 20 ns, permet un traitement amélioré de la surface, plus particulièrement pour obtenir la structure de nodules.

Pour balayer le faisceau laser 5 sur la surface 100a du corps 10, le faisceau laser 5 peut être focalisé puis balayé par un équipement approprié. Le traitement laser est adapté au traitement de zones difficiles d'accès, telles que des cavités, des replis formés par une forme complexe du corps 10. Le traitement laser peut donc être effectué sur des pièces à géométries complexe. Selon un exemple, le faisceau laser peut être transmis par une tête galvanométrique 52, équipée de deux miroirs permettant d'orienter 50 le faisceau laser en x et en y, comme illustré par les figures 5 et 6.

Pour permettre le traitement laser, on comprend néanmoins qu'il faut qu'un chemin optique soit possible de l'émission du faisceau laser 5 à la surface 100a. Ceci peut éventuellement limiter le nombre d'ailettes pouvant être disposées et traitées sur un dissipateur thermique. Toutefois, l'augmentation du pouvoir dissipant du dissipateur peut compenser cette réduction du nombre d'ailettes, ce qui permettrait en outre de limiter le poids du dissipateur.

De préférence, la profondeur de champ $P_5$ du faisceau laser 5 est sensiblement égale à 3 mm. Ainsi, le traitement laser peut accommoder des différences de hauteurs à la surface 100a, par exemple des reliefs, dans une gamme de +/- 1,5 mm. En outre, le procédé peut comprendre un ajustement de la distance $D_5$ entre l'émission du laser et la surface 100a, pour améliorer la tolérance des dénivelés de la surface 100a. La distance D5 peut par exemple être sensiblement comprise entre 10 cm et 50 cm, de préférence sensiblement égale à 20 cm. La distance D5 peut en outre être supérieure à la gamme indiquée, par exemple lorsqu'un laser à fibre optique est utilisé.

Le faisceau laser 5 est balayé sur la surface 100a avec un taux de recouvrement sensiblement supérieur ou égal à 60 %. Par taux de recouvrement, on entend la surface de recouvrement entre deux ou plus zones d'impact 51. Les impulsions peuvent être successives ou non. Selon l'exemple illustré par la [Fig.6], on comprend que ce recouvrement s'entend dans le plan (x,y) de la surface 100a. Ainsi, ce taux de recouvrement peut être obtenu lors d'un balayage en x seulement du faisceau laser 5, ou par combinaison entre deux ou plus balayages en x du faisceau laser 5, deux balayages étant séparés d'une distance $\Delta y$. Ces balayages peuvent être successifs ou non. Il a en effet été observé lors du développement de l'invention que le temps entre les impulsions laser ne jouait que très peu, voire pas, sur les caractéristiques obtenues. De préférence, le taux de recouvrement est sensiblement supérieur ou égal à 70 %, et plus préférentiellement encore sensiblement égal à 75 %. Plus le taux de recouvrement est grand, plus la vitesse de balayage du faisceau diminue. Un taux de recouvrement de 75 % représente un bon compromis entre la vitesse de traitement laser et l'amélioration des propriétés émissives du dissipateur 1. Le traitement laser peut par exemple présenter une vitesse de traitement sensiblement supérieure à 300mm$^2$.s$^{-1}$.

La vitesse de traitement V (en mm$^2$.s$^{-1}$) peut par exemple être donnée par l'expression suivante :

[Math.1]

$$V = \left\{ \frac{Pmoy}{D_p \times t_p \times \pi \left(\frac{d}{2}\right)^2} \right\} \times (d \times (1 - \tau))^2$$

Avec Pmoy la puissance moyenne du laser, $D_p$ la densité de puissance, $t_p$ la durée d'une impulsion laser, d le diamètre de la zone d'impact et $\tau$ le taux de recouvrement. La partie entre accolades de l'expression ci-dessus correspond à la fréquence de tir laser en Hz.

La taille du faisceau laser 5 à la zone d'impact 51, peut être choisie de sorte que le traitement laser est appliqué dans des zones bien définies, dans des zones étroites, ou encore sur des grandes surfaces. Le diamètre $D_{51}$ de la zone d'impact 51 peut être choisi sur une plage de valeur allant de quelques dizaines de $\mu$m à plusieurs cm, de préférence de quelques dizaines de $\mu$m à plusieurs centaines de $\mu$m, cette valeur sera à choisir en fonction de la taille de la zone à traiter. Selon un exemple, le diamètre $D_{51}$ est sensiblement inférieur à 500 $\mu$m, de préférence à 400 $\mu$m, et plus préférentiellement encore à 100 $\mu$m. Ainsi des motifs spécifiques et/ou complexes peuvent être réalisés par le traitement laser, avec une résolution jusqu'à quelques dizaines de $\mu$m. Il est ainsi possible de créer des chemins et des zones localisées de dissipation thermique améliorée sur le dissipateur 1.

La longueur d'onde du faisceau laser 5 peut être choisie dans l'infra-rouge, dans le visible, ou bien dans l'ultraviolet. Le décalage des longueurs d'onde vers les hautes énergies favorise les interactions avec la surface 100a et l'efficacité de son oxydation pour former la couche superficielle 100.

Le traitement laser peut se faire sous air ambiant, facilitant sa mise en œuvre. Le coût du procédé et du dissipateur en résultant est donc réduit. En outre, des pièces de grandes dimensions peuvent être traitées sans nécessiter un réacteur pour acheminer des gaz. En alternative, le traitement laser peut être effectué sous une atmosphère réactive, et plus particulièrement sous une atmosphère oxydante pour améliorer le processus de création de la couche superficielle 102 d'oxyde. L'atmosphère oxydante peut notamment présenter une proportion en un gaz oxydant, par exemple le dioxygène, supérieure à 20 %.

Notons que le procédé peut comprendre toute étape configurée pour obtenir une caractéristique décrite du dissipateur. Le dissipateur peut en outre présenter toute caractéristique résultant de la mise en œuvre d'une étape du procédé.

Un exemple particulier du procédé de fabrication est maintenant décrit, dans lequel le laser est un laser Nd :YAG Q-Switché (de longueur d'onde 1064 nm), générant des impulsions pour lesquelles :

- $t_p$ est égale à 10 ns,
- Pmoy est égale à 40 W,
- $D_p$ est égale à 100 MW/cm$^2$,
- la zone d'impact est circulaire avec un diamètre d de 400 $\mu$m,
- le taux de recouvrement $\tau$ est de 75 %,
- la profondeur de champ est de 3 mm,
- la fréquence de tir laser est d'environ 32 kHz,
- la vitesse de traitement V est de 318 mm$^2$.s$^{-1}$.

La surface obtenue est illustrée par les clichés de microscopie électronique à balayage en [Fig.7] et 8, et présente bien les caractéristiques précédemment décrites.

Une simulation a en outre été réalisée entre un dissipateur non traité, et un dissipateur de même structure et présentant les caractéristiques de la structure décrite en exemple ci-dessus, suite à un traitement laser. Les deux dissipateurs sont montés avec une LED: NC2W321BT-M700 fonctionnant à une puissance de 4.12 W, dans un environnement non confiné, à une température ambiante de 25°C. Le dissipateur non traité présente une émissivité de 0,08, alors que l'émissivité du dissipateur selon l'invention présente une émissivité de 0,7. Une augmentation d'un facteur 8,75 du pouvoir dissipant du dissipateur est ainsi prévue grâce au traitement laser. Ces simulations ont été complétées de mesures d'émissivité sur des échantillons.

D'une manière générale selon l'invention, le procédé selon l'invention permet de réaliser la couche superficielle de manière à ce qu'elle présente un taux de porosité en volume inférieure à 4%. Cela permet d'avoir de meilleures propriétés radiatives en absorption et en émission.

Au vu de la description qui précède, il apparaît clairement que l'invention propose un dissipateur thermique amélioré et un procédé de fabrication amélioré d'un dissipateur thermique par rapport aux solutions existantes.

L'invention n'est pas limitée aux modes de réalisations précédemment décrits et s'étend à tous les modes de réalisation couverts par l'invention. La présente invention ne se limite pas aux exemples précédemment décrits. L'invention est définie par les revendications annexées.

LISTE DES REFERENCES NUMERIOUES

1 Dissipateur
10 Corps
100 Couche extérieure
100a Surface de la couche extérieure
100b Composés résiduels
101 Couche superficielle
101a Surface de la couche superficielle
102 Couche sous-jacente
103 Nodule
11 Ailette
2 Composant électronique
20 Diode électroluminescente
3 Circuit imprimé
30 Interface thermique
4 Dispositif
40 Réflecteur
5 Faisceau laser
50 Orientation du faisceau
51 Zone d'impact

**Revendications**

1. Dissipateur (1) thermique pour composant électronique (2) comprenant :

   • un corps (10) doté d'une couche extérieure (100), comprenant une couche superficielle (101) présentant une surface exposée (101a) radiative et une couche immédiatement sous-jacente (102) à la couche superficielle (101),

   dans lequel :

   • la couche sous-jacente (102) est en matériau fait d'un métal ou d'un alliage de métaux et la couche superficielle (101) est faite d'un oxyde dudit matériau, et
   • la couche extérieure (100) comprend des nodules (103) juxtaposés,

   **caractérisé en ce que** la couche superficielle (101) présente une épaisseur moyenne ($D_{101}$) comprise entre 5 $\mu$m et 30 $\mu$m.

2. Dissipateur (1) selon la revendication précédente, dans lequel le métal est choisi parmi le magnésium, le fer, l'acier, cuivre et l'aluminium.

3. Dissipateur (1) selon la revendication précédente, dans lequel le métal est de l'aluminium et l'oxyde est de l'alumine.

4. Dissipateur (1) selon l'une quelconque des revendications précédentes, dans lequel la couche superficielle (101) présente un taux de porosité en volume inférieure à 4%.

5. Dissipateur (1) selon l'une quelconque des revendications précédentes, dans lequel les nodules (103) sont de forme globalement cylindrique.

6. Dissipateur (1) selon l'une quelconque des revendications précédentes, dans lequel chaque nodule (103) présente une section de forme variable sur la hauteur de ce nodule.

7. Dissipateur (1) selon l'une quelconque des revendications précédentes, dans lequel les nodules (103) présentent en moyenne :

   • une première dimension ($D_{103}$) selon une direction parallèle au plan d'extension principale de la couche extérieure (100), inférieure ou égale à 50 $\mu$m,
   • une deuxième dimension ($H_{103}$) selon une direction normale au plan d'extension principale de la couche extérieure (100), inférieure ou égale à 50 $\mu$m.

8. Dissipateur (1) selon l'une quelconque des revendications précédentes, dans lequel les nodules (103) sont espacés entre eux d'une distance moyenne ($S_{103}$), selon une direction parallèle au plan d'extension principale de la couche extérieure (100), sensiblement inférieure ou égale à 50 $\mu$m.

9. Dissipateur (1) selon l'une quelconque des revendications précédentes, dans lequel les nodules (103) sont formés d'une combinaison de la couche superficielle (101) et d'au moins une partie de la couche sous-jacente (102).

10. Procédé de fabrication d'un dissipateur thermique (1) pour composant électronique (2), comprenant :

    • une fourniture d'un corps (10) de dissipateur (1) doté d'une couche extérieure (100) en matériau fait d'un métal ou d'un alliage de métaux et présentant une surface (100a),
    • un traitement d'au moins une partie de la surface (100a) de la couche extérieure (100) comprenant l'application d'un faisceau laser (5) impulsionnel dans laquelle :

      ∘ la durée d'une impulsion du faisceau laser (5) est inférieure ou égale à 100 ns,
      ∘ le faisceau laser (5) présente une densité de puissance supérieure ou égale à 100 MW.cm$^{-2}$,
      ∘ le faisceau laser (5) est balayé sur la partie de la surface de la couche superficielle avec un taux de recouvrement supérieur ou égal à 60 % entre plusieurs impulsions distinctes,

    de façon à former, à partir de la couche extérieure (100) du corps (10) une couche superficielle (101) présentant une surface exposée (101a) radiative et une couche immédiatement sous-jacente (102) à la couche superficielle (101), la couche sous-jacente (102) étant en matériau fait dudit métal ou dudit alliage et la couche superficielle (101) étant faite d'un oxyde dudit matériau, la couche extérieure (100) présentant des nodules (103) juxtaposés d'oxyde dudit matériau,

    **caractérisé en ce que**
    la couche superficielle présente une épaisseur moyenne comprise entre 5 $\mu$m et 30 $\mu$m.

11. Procédé selon la revendication précédente, dans lequel la durée des impulsions laser est inférieure à 20 ns.

12. Procédé selon l'une quelconque des deux revendications précédentes, dans lequel le taux de recouvrement est supérieur ou égal à 75 %.

13. Procédé selon l'une quelconque des trois revendications précédentes, dans lequel, lors de l'impulsion du faisceau laser (5), la zone d'impact (51) du faisceau laser sur la surface (100a) de la couche extérieure (100) présente une plus grande dimension latérale ($D_{51}$) inférieure à 500 $\mu$m.

14. Dispositif (4) comprenant au moins un composant électronique (2) monté en conduction thermique sur le dissipateur thermique (1) selon l'une quelconque des revendications 1 à 9.

**15.** Dispositif (4) selon la revendication précédente, dans lequel le compostant électronique (2) est une diode électroluminescente.

**16.** Dispositif (4) selon l'une quelconque des deux revendications précédentes, le dispositif étant un dispositif lumineux (4) d'éclairage ou de signalisation de véhicule automobile.

**Patentansprüche**

**1.** Wärmeableiter (1) für eine elektronische Komponente (2), comprising:

- einen Körper (10) mit einer Außenschicht (100), umfassend eine Oberflächenschicht (101) mit einer exponierten Strahlungsoberfläche (1o1a) und einer unmittelbar unter der Oberflächenschicht (101) liegenden Schicht (102),

wobei:

- die untere Schicht (102) aus einem Material besteht, das ein Metall oder eine Legierung von Metallen ist, und die Oberflächenschicht (101) aus einem Oxid des genannten Materials besteht, und
- die Außenschicht (100) nebeneinanderliegende Knötchen (103) umfasst,

**dadurch gekennzeichnet, dass** die Oberflächenschicht (101) eine durchschnittliche Dicke (D101) zwischen 5 $\mu$m und 30 $\mu$m aufweist.

**2.** Wärmeableiter (1) nach dem vorhergehenden Anspruch, wobei das Metall aus Magnesium, Eisen, Stahl, Kupfer und Aluminium ausgewählt ist.

**3.** Wärmeableiter (1) nach dem vorhergehenden Anspruch, wobei das Metall Aluminium und das Oxid Aluminiumoxid ist.

**4.** Wärmeableiter (1) nach einem der vorhergehenden Ansprüche, wobei die Oberflächenschicht (101) eine volumetrische Porosität von weniger als 4 % aufweist.

**5.** Wärmeableiter (1) nach einem der vorhergehenden Ansprüche, wobei die Knötchen (103) eine im Wesentlichen zylindrische Form aufweisen.

**6.** Wärmeableiter (1) nach einem der vorhergehenden Ansprüche, wobei jedes Knötchen (103) einen Querschnitt mit variabler Form über die Höhe dieses Knötchens aufweist.

**7.** Wärmeableiter (1) nach einem der vorhergehenden Ansprüche, wobei die Knötchen (103) im Durchschnitt aufweisen:

- eine erste Abmessung (D103) in einer Richtung parallel zur Haupterstreckungsebene der Außenschicht (100), kleiner oder gleich 50 $\mu$m,
- eine zweite Abmessung (H103) in einer Richtung normal zur Haupterstreckungsebene der Außenschicht (100), kleiner oder gleich 50 $\mu$m.

**8.** Wärmeableiter (1) nach einem der vorhergehenden Ansprüche, wobei die Knötchen (103) voneinander durch einen durchschnittlichen Abstand (S103) in einer Richtung parallel zur Haupterstreckungsebene der Außenschicht (100) beabstandet sind, der im Wesentlichen kleiner oder gleich 50 $\mu$m ist.

**9.** Wärmeableiter (1) nach einem der vorhergehenden Ansprüche, wobei die Knötchen (103) aus einer Kombination der Oberflächenschicht (101) und mindestens einem Teil der darunterliegenden Schicht (102) gebildet sind.

**10.** Verfahren zur Herstellung eines Wärmeableiters (1) für eine elektronische Komponente (2), umfassend:

- Bereitstellen eines Körpers (10) des Wärmeableiters (1) mit einer Außenschicht (100) aus einem Material, das ein Metall oder eine Legierung von Metallen ist, und einer Oberfläche (100a),

EP 4 315 437 B1

- Behandeln mindestens eines Teils der Oberfläche (100a) der Außenschicht (100), umfassend das Anwenden eines gepulsten Laserstrahls (5), wobei:

  ∘ die Dauer eines Impulses des Laserstrahls (5) kleiner oder gleich 100 ns ist,
  ∘ der Laserstrahl (5) eine Leistungsdichte von größer oder gleich 100 MW.cm-2 aufweist,
  ∘ der Laserstrahl (5) über den Teil der Oberfläche der Oberflächenschicht mit einer Überlappungsrate von größer oder gleich 60 % zwischen mehreren einzelnen Impulsen gescannt wird,

um aus der Außenschicht (100) des Körpers (10) eine Oberflächenschicht (101) mit einer exponierten Strahlungsoberfläche (1o1a) und einer unmittelbar unter der Oberflächenschicht (101) liegenden Schicht (102) zu bilden, wobei die untere Schicht (102) aus dem genannten Metall oder der genannten Legierung besteht und die Oberflächenschicht (101) aus einem Oxid des genannten Materials besteht, wobei die Außenschicht (100) nebeneinanderliegende Knötchen (103) aus dem Oxid des genannten Materials aufweist,

**dadurch gekennzeichnet, dass** die Oberflächenschicht eine durchschnittliche Dicke zwischen 5 $\mu$m und 30 $\mu$m aufweist.

11. Verfahren nach dem vorhergehenden Anspruch, wobei die Dauer der Laserimpulse kleiner als 20 ns ist.

12. Verfahren nach einem der beiden vorhergehenden Ansprüche, wobei die Überlappungsrate größer oder gleich 75 % ist.

13. Verfahren nach einem der drei vorhergehenden Ansprüche, wobei während des Impulses des Laserstrahls (5) die Aufprallzone (51) des Laserstrahls auf der Oberfläche (100a) der Außenschicht (100) eine größte seitliche Abmessung (D51) von weniger als 500 $\mu$m aufweist.

14. Vorrichtung (4), umfassend mindestens eine elektronische Komponente (2), die in Wärmeleitung auf dem Wärmeableiter (1) nach einem der Ansprüche 1 bis 9 montiert ist.

15. Vorrichtung (4) nach dem vorhergehenden Anspruch, wobei die elektronische Komponente (2) eine Leuchtdiode ist.

16. Vorrichtung (4) nach einem der beiden vorhergehenden Ansprüche, wobei die Vorrichtung eine Lichtvorrichtung (4) zur Beleuchtung oder Signalisierung eines Kraftfahrzeugs ist.

**Claims**

1. Heat sink (1) for an electronic component (2) comprising:

   - a body (10) provided with an outer layer (100), comprising a surface layer (101) having an exposed radiative surface (101a) and an immediately underlying layer (102) to the surface layer (101),

   wherein:

   - the underlying layer (102) is made of a material made of a metal or an alloy of metals, and the surface layer (101) is made of an oxide of said material, and
   - the outer layer (100) comprises juxtaposed nodules (103),

   **characterized in that** the surface layer (101) has an average thickness (D101) of between 5 $\mu$m and 30 $\mu$m.

2. Heat sink (1) according to the preceding claim, wherein the metal is selected from among magnesium, iron, steel, copper, and aluminum.

3. Heat sink (1) according to the preceding claim, wherein the metal is aluminum and the oxide is alumina.

4. Heat sink (1) according to any one of the preceding claims, wherein the surface layer (101) has a porosity rate by volume of less than 4%.

5. Heat sink (1) according to any one of the preceding claims, wherein the nodules (103) are generally cylindrical in shape.

6. Heat sink (1) according to any one of the preceding claims, wherein each nodule (103) has a cross-section of variable shape over the height of this nodule.

7. Heat sink (1) according to any one of the preceding claims, wherein the nodules (103) have on average:

- a first dimension (D103) in a direction parallel to the main extension plane of the outer layer (100), less than or equal to 50 $\mu$m,
- a second dimension (H103) in a direction normal to the main extension plane of the outer layer (100), less than or equal to 50 $\mu$m.

8. Heat sink (1) according to any one of the preceding claims, wherein the nodules (103) are spaced from each other by an average distance (S103), in a direction parallel to the main extension plane of the outer layer (100), substantially less than or equal to 50 $\mu$m.

9. Heat sink (1) according to any one of the preceding claims, wherein the nodules (103) are formed by a combination of the surface layer (101) and at least part of the underlying layer (102).

10. Method for manufacturing a heat sink (1) for an electronic component (2), comprising:

- providing a body (10) of the heat sink (1) provided with an outer layer (100) made of a material consisting of a metal or an alloy of metals and having a surface (100a)
- treating at least part of the surface (100a) of the outer layer (100) comprising the application of a pulsed laser beam (5) in which:

  ○ the duration of a pulse of the laser beam (5) is less than or equal to 100 ns,
  ○ the laser beam (5) has a power density greater than or equal to 100 MW.cm-2,
  ○ the laser beam (5) is scanned over the part of the surface of the surface layer with an overlap rate greater than or equal to 60% between several distinct pulses,

so as to form, from the outer layer (100) of the body (10), a surface layer (101) having an exposed radiative surface (101a) and an immediately underlying layer (102) to the surface layer (101), the underlying layer (102) being made of a material made of said metal or said alloy and the surface layer (101) being made of an oxide of said material, the outer layer (100) having juxtaposed nodules (103) of oxide of said material,

**characterized in that** the surface layer has an average thickness of between 5 $\mu$m and 30 $\mu$m.

11. Method according to the preceding claim, wherein the duration of the laser pulses is less than 20 ns.

12. Method according to any one of the two preceding claims, wherein the overlap rate is greater than or equal to 75%.

13. Method according to any one of the three preceding claims, wherein, during the pulse of the laser beam (5), the impact zone (51) of the laser beam on the surface (100a) of the outer layer (100) has a largest lateral dimension (D51) of less than 500 $\mu$m.

14. Device (4) comprising at least one electronic component (2) mounted in thermal conduction on the heat sink (1) according to any one of claims 1 to 9.

15. Device (4) according to the preceding claim, wherein the electronic component (2) is a light-emitting diode.

16. Device (4) according to any one of the two preceding claims, the device being a light device (4) for lighting or signaling of a motor vehicle.

[Fig. 1]

FIG. 1

[Fig. 2]

FIG. 2

[Fig. 3]

FIG. 3

[Fig. 4]

FIG. 4

[Fig. 5A]

FIG. 5A

[Fig. 5B]

FIG. 5B

[Fig. 6]

FIG. 6

[Fig. 7]

FIG. 7

[Fig. 8]

FIG. 8

# EP 4 315 437 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070210265 A1
- US 2019206761 A1
- KR 20130096884 A